# EUROPEAN PATENT SPECIFICATION

(11) **EP 4 218 951 B1**
(45) Date of publication and mention of the grant of the patent: **13.05.2026**
(21) Application number: 23153105.4
(22) Date of filing: 24.01.2023
(51) Int. Cl.: A62C 3/16, G01K 7/16, G01K 11/06

(54) **ENERGY STORAGE SYSTEM**
ENERGIESPEICHERSYSTEM
SYSTÈME DE STOCKAGE D'ÉNERGIE

(30) Priority: 27.01.2022 KR 20220012601
(43) Date of publication of application: 02.08.2023
(73) Proprietor: Samsung SDI Co., Ltd., Yongin-si, Gyeonggi-do 17084 (KR)
(72) Inventor: KANG, Sung Koo, 17084 Yongin-si (KR); EOM, Jae Pil, 17084 Yongin-si (KR); PARK, Jeong Keun, 17084 Yongin-si (KR); SEO, Jea Won, 17084 Yongin-si (KR); LIM, Hyung Hoon, 17084 Yongin-si (KR)
(74) Representative: Marks & Clerk LLP

(56) References cited:
- EP-A1- 3 757 590
- WO-A1-2021/025539
- WO-A1-2021/045410

## Description

### BACKGROUND

### 1. Field

The present disclosure relates to an energy storage system capable of accurately detecting a module where an event has occurred and injecting a fire extinguishing agent.

### 2. Description of the Related Art

An energy storage system may be linked with a renewable energy system, such as a solar cell, and may be configured to store power when electric power demand is low and to use the stored power at a time when electric power demand is high, and refers to an apparatus including a large number of battery cells composed of secondary batteries.

Generally, an energy storage system is configured such that multiple battery cells are received in multiple trays, which are received in a rack, and multiple racks are received in a container box.

Meanwhile, recently, there have been cases of fires occurring in energy storage systems. Due to the nature of energy storage modules, when a fire occurs, there is a problem in that it is not easy to extinguish the fire. An energy storage module consists of a plurality of battery cells, and thus it is common to have high capacity and high output. Accordingly, a technology for increasing the safety of an energy storage module is being researched. Prior art document 1 [WO 2021025539 A1] discloses a battery pack in which the risk of secondary ignition or explosion is reduced. The battery pack comprises at least two battery modules arranged in one direction and an extinguishment unit. Prior art document 2 [WO 2021045410 A1] discloses a battery pack which reduces the risk of secondary ignition or explosion. The battery pack comprises at least two battery modules arranged in one direction and a fire extinguishing unit having a fire extinguishing tank in which a fire extinguishing agent is housed. Prior art document 3 [EP3757590 A1] discloses a circuit for detecting thermal runaway, which relates to the technical field of batteries. The circuit for detecting thermal runaway includes a sensing module including a sensing line, wherein a distance between at least a portion of the sensing line and a single battery cell in a battery set is less than a temperature-sensing distance threshold.

### SUMMARY

The present disclosure provides an energy storage system capable of accurately detecting a module where an event has occurred and injecting a fire extinguishing agent.

These and other aspects and features of the present disclosure will be described in or will be apparent from the following description of embodiments of the present disclosure.

The invention is set out in the appended set of claims. An energy storage system according to the invention includes: a rack having a space inside; a plurality of modules accommodated in the rack and including a plurality of battery cells arranged in one direction therein; and a sensing line formed along one side of the plurality of modules, respectively.

Here, the sensing line may be disposed in the same direction as one direction in which the plurality of battery cells are arranged in the plurality of modules.

In addition, the sensing line may be arranged in alternating directions for the plurality of modules positioned vertically in the rack.

In addition, the sensing line may be configured as a constant-temperature sensing linear sensor.

In addition, the sensing line may have a wiring structure formed by twisting a steel wire coated with a temperature sensitive material.

According to the invention, power and ground lines are connected to both ends of the sensing line.

According to the invention, a shunt resistor connected in series with the sensing line exists between the power and ground lines, and a controller connected to the shunt resistor is further provided.

In addition, the controller may receive (e.g. may be configured to receive) a voltage of both ends of the shunt resistor as an input value.

In addition, a fire extinguishing system that is connected in parallel with the controller and receives (e.g. may be configured to receive) a voltage of both ends of the shunt resistor as an input value may be further included.

In addition, the controller or the fire extinguishing system may apply (e.g. may be configured to apply) a control signal to spray a fire extinguishing agent to the fire extinguishing device when the voltage across the shunt resistor is sensed.

At least some of the above and other features of the invention are set out in the claims.

### BRIEF DESCRIPTION OF DRAWINGS

FIG. 1 is a perspective view showing the configuration of a rack in an energy storage system according to an embodiment of the present invention.
FIG. 2 is a conceptual diagram illustrating a method for installing a sensing line at a lower end of a rack in an energy storage system according to an embodiment of the present invention.
FIG. 3 is a structural diagram illustrating a sensing line used in an energy storage system according to an embodiment of the present invention.
FIGS. 4A and 4B are conceptual diagrams illustrating operations when an event occurs in an energy storage system according to an embodiment of the present invention.
FIGS. 5A and 5B are conceptual diagrams illustrating operations when an event occurs in an energy storage system according to another embodiment of the present invention.

### DETAILED DESCRIPTION

Example embodiments will now be described more fully hereinafter with reference to the accompanying drawings, however, they may be embodied in different forms and should not be construed as limited to the embodiments set forth herein. Rather, these embodiments are provided so that this disclosure will be thorough and complete, and will fully convey the scope of the invention to those skilled in the art.

In the drawings, the thickness of layers, films, panels, regions, etc., are exaggerated for clarity. Like reference numerals designate like elements throughout the specification. As used herein, the term "and/or" includes any and all combinations of one or more of the associated listed items. In addition, it will be understood that when an element A is referred to as being "connected to" an element B, the element A can be directly connected to the element B or an intervening element C may be present therebetween such that the element A and the element B are indirectly connected to each other.

The terminology used herein is for the purpose of describing particular embodiments only and is not intended to be limiting of the disclosure. As used herein, the singular forms are intended to include the plural forms as well, unless the context clearly indicates otherwise. It will be further understood that the terms "comprise or include" and/or "comprising or including," when used in this specification, specify the presence of stated features, numbers, steps, operations, elements, and/or components, but do not preclude the presence or addition of one or more other features, numbers, steps, operations, elements, components, and/or groups thereof.

It will be understood that, although the terms first, second, etc. may be used herein to describe various members, elements, regions, layers and/or sections, these members, elements, regions, layers and/or sections should not be limited by these terms. These terms are only used to distinguish one member, element, region, layer and/or section from another. Thus, for example, a first member, a first element, a first region, a first layer and/or a first section discussed below could be termed a second member, a second element, a second region, a second layer and/or a second section without departing from the teachings of the present disclosure.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the element or feature in the figures is turned over, elements described as "below" or "beneath" other elements or features would then be oriented "on" or "above" the other elements or features. Thus, the term "below" can encompass both an orientation of above and below.

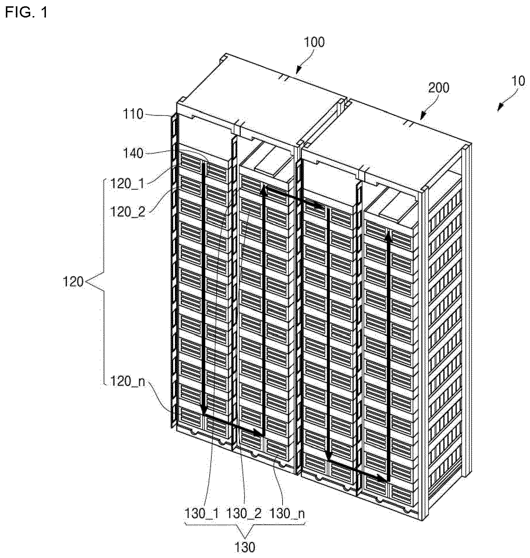

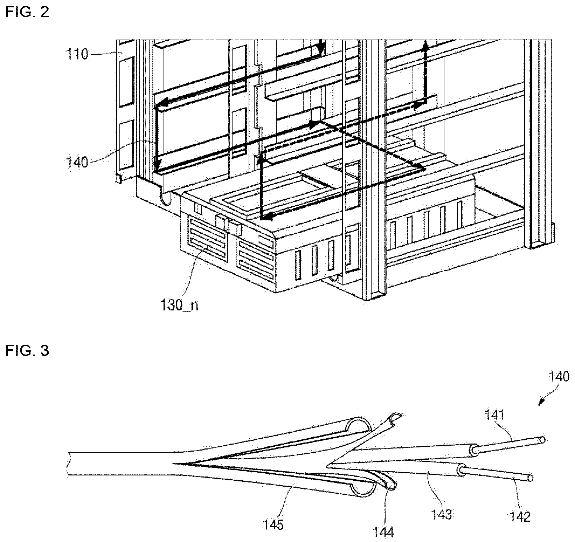

Hereinafter, prior to describing an electrode assembly according to an embodiment of the present invention with reference to the accompanying drawings, a general electrode assembly structure will first be described. FIG. 1 is a perspective view showing the configuration of a rack in an energy storage system according to an embodiment of the present invention. FIG. 2 is a conceptual diagram illustrating a method for installing a sensing line at a lower end of a rack in an energy storage system according to an embodiment of the present invention.

First, referring to FIG. 1, an energy storage system 10 according to an embodiment of the present invention includes one or more racks 100 and 200. Here, since the second or subsequent rack 200 is the same as the first rack 100, for convenience, the first rack 100 (hereinafter referred to as 'rack') will be mainly described.

As shown in FIG. 1, the rack 100 may include a rack frame 110, and includes a plurality of battery modules 120 and 130 accommodated in the rack frame 110, and a sensing line 140 formed along the battery modules 120 and 130.

The rack frame 110 may have accommodation spaces divided at regular intervals inside. A plurality of battery modules 120 and 130 may be accommodated in the rack frame 110. In addition, a circuit board including a module battery management system (BMS) may be coupled to the rear surface of the rack frame 110 to perform sensing and control of the respective battery modules 120 and 130. In addition, as will later be described, a sensing line 140 is formed along the rack frame 110 to sense an event occurring in the battery module 120, 130.

Inside each of the battery modules 120 and 130, a plurality of battery cells are arranged and connected in various ways in series, parallel, or series/parallel according to a required output. In such a battery cell, an electrode assembly may be accommodated inside a case, and the electrode assembly may be configured to be wound, stacked, or laminated in a state in which a separator is placed between a positive electrode plate and a negative electrode plate having a region, for example, a coating portion, coated with an active material. In addition, the top portion of the case may be sealed by a cap plate. In addition, in a battery cell, electrode terminals electrically connected to uncoated portions of the positive electrode plate and the negative electrode plate may be exposed above the cap plate. In addition, a vent having a thickness smaller than that of other regions may be formed at an approximate center of the cap plate, and when the internal pressure of the battery cell rises above a reference level, the vent may be opened to discharge gas to the outside to prevent explosion.

In addition, the battery modules 120 and 130 may also be connected in various ways in series, parallel, or series/parallel, respectively, so that a desired output may be generated in the rack 100.

The sensing line 140 is formed along one side of each of the battery modules 120 and 130. Accordingly, when an event, such as opening of a vent or a fire, occurs in some of the battery cells of the battery modules 120 and 130, the position of the corresponding battery cell may be sensed through the sensing line 140, and accordingly, the operation of spraying a fire extinguishing agent may be accompanied.

Referring to FIG. 1, the arrangement of the sensing line 140 within the rack 100 will be described. The sensing line 140 may be arranged to sequentially pass from the first module 120_1 of a first sub-module 120 positioned at the topmost of one side to the n-th module 120_n positioned at the bottommost, on the basis of the rack 100. In addition, the sensing line 140 may be arranged to sequentially pass from the n-th module 130_n of the second sub-module 130 positioned at the bottommost of the other side of the rack 100 to the first module 130_1 positioned at the topmost. According to this arrangement, since the sensing line 140 passes through all modules 120_1 to 120_n and 130_1 to 130_n constituting the rack 100, when an event occurs in a battery cell in a specific module, the position of the corresponding battery cell can be sensed.

Specifically, referring to FIG. 2, the sensing line 140 may be disposed along one surface of each module, for example, the lower surface. As shown by a solid line in FIG. 2, when the sensing line 140 is disposed with respect to the first sub-module 120, the sensing line 140 may be formed along the front or rear end of the module to then be disposed along the lower surface of the module. Accordingly, the sensing line 140 may be arranged in the same direction as the direction in which the cell is arranged in the module. In addition, in this state, when the sensing line 140 is coupled to a next module, the sensing line 140 is again arranged along the front or rear end of the module to then be disposed along the lower surface of the module. The arrangement shape of the sensing line 140 will be described on the basis of the direction within each module. The sensing line 140 may be disposed on the lower surface of the first module 120_1 of the first sub-module 120 in a direction from the front end to the rear end, may be disposed on the lower surface of the second module 120_2 in a direction from the rear end to the front end, and may be disposed on the lower surface of the third module 120_3 in a direction from the front end to the rear end. That is, on the basis of the lower surfaces of the modules 120_1 to 120_n of the first sub-module 120, the sensing line 140 may be arranged alternately from the front end to the rear end and from the rear end to the front end. However, even with this arrangement, the sensing line 140 passes through the lower surfaces of the respective modules 120_1 to 120_n in the same direction as the arrangement of battery cells, and thus it may be possible to detect an event of a specific battery cell.

In addition, as shown in FIG. 2, the sensing line 140, the arrangement of which has been completed to the lower surface of the n-th module 120_n that is the bottommost of the sub-module 120, may be disposed along the lower surface of the n-th module 130_n of the second sub-module 130 adjacent thereto. Thereafter, the wiring of the sensing line 140 in the rack 100 may be completed by passing through all the modules positioned above the n-th module 130_n and finally passing through to the lower surface of the first module 130_1 at the top end. However, according to the selection of a person skilled in the art, the sensing line 140 may be further disposed in the same manner with respect to adjacent racks 200.

Hereinafter, a configuration of a sensing line of an energy storage system according to an embodiment of the present invention will be described in more detail.

FIG. 3 is a structural diagram illustrating a sensing line used in an energy storage system according to an embodiment of the present invention.

The operating principle of the sensing line 140 may use a twisting force in which intertwisted steel wires are attempted to return to a circular shape.

The sensing line 140 may be configured such that the exterior sides of steel wires are covered with temperature sensitive materials 141 and 142 having very small heat-resistant performance and being electrical insulating materials, the two insulated steel wires are then twisted and wrapped with a protective tape 143, and the exterior sides thereof are coated with an insulating molten material 144 and a flame retardant material 145. In case of overheating or fire, in the sensing line 140, as the temperature sensitive materials 141 and 142 melt due to heat or flames, the twisted steel wires come into contact with each other, resulting in a short circuit between the wires, and a short circuit current flows between the two wires. The temperature sensitive materials 141 and 142 may be set to be melted at a temperature of 80 to 120 degrees. Accordingly, when a vent is opened or a fire occurs in a specific battery cell and reaches a corresponding temperature range, the temperature sensitive materials 141 and 142 are melted, and internal steel wires contact each other, causing a short circuit.

In addition, when the resistance of a steel wire up to a point of short-circuit of the sensing line 140 is known in advance from a controller, which will be described later, the controller may be aware of which point the short-circuit occurred by using short-circuit current. In addition, as described above, the sensing line 140 is disposed along the lower surface of the modules 120_1 to 130_n disposed in all the racks 100 and 200, and thus each battery cell in each module has a different distance from the controller. Therefore, the controller can identify accurate positions of the racks 100 and 200 or the sub-modules 120 and 130, as well as the battery cells, through the short-circuit current.

Hereinafter, the operation of a controller when an event occurs in an energy storage system according to an embodiment of the present invention will be described.

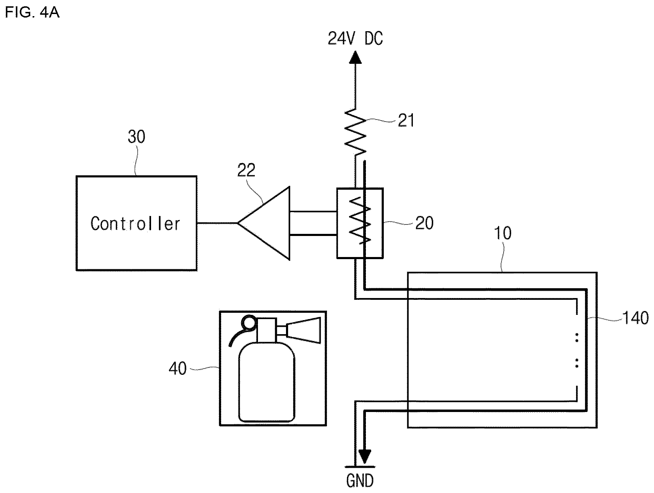

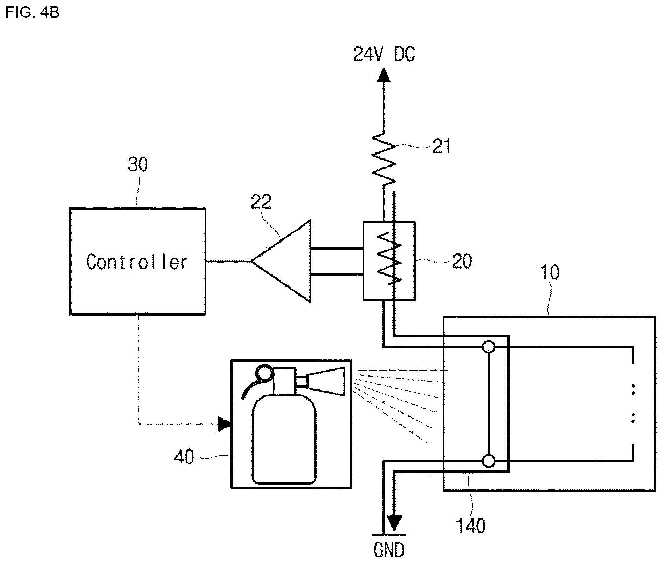

FIGS. 4A and 4B are conceptual diagrams illustrating operations when an event occurs in an energy storage system according to an embodiment of the present invention.

Referring to FIG. 4A, the sensing line 140 in the energy storage system 10 is connected between a power supply (24V DC) and a ground (GND) through a shunt resistor 20 and a current limiting resistor 21. In addition, both ends of the shunt resistor 20 may be connected to the controller 30 through an amplifier circuit 22, and a fire extinguishing device 40 equipped with a fire extinguishing agent may be disposed inside or near the energy storage system 10.

In this state, a controller 30 checks the presence or absence of a short circuit current flowing through the sensing line 140 and the magnitude of the short circuit current in real time through the voltage of the shunt resistor 20. In a normal state, since no short-circuit current is generated in the sensing line 140, the voltage across the shunt resistor 20 may be displayed as 0 V.

Meanwhile, referring to FIG. 4B, when an event, such as opening of a vent or fire, in some of battery cells in the energy storage system 10, occurs, the temperature sensitive materials 141 and 142 of the sensing line 140 are melted, and the steel wires come into contact with each other, causing a short circuit. In addition, a short-circuit current may be generated due to a potential difference between the power supply (24V DC) applied to both ends of the sensing line 140 and the ground (GND), so that a voltage may also be generated at both ends of the shunt resistor 20. Of course, as described above, the position of the short circuit of the sensing line 140 may change according to the position of the battery cell where the event occurs, and the resistance may change, and thus the magnitudes of the short-circuit current and the voltage across the shunt resistor 20 may also vary. Therefore, the controller 30 senses the position of the battery cell as well as the modules 120_1 to 130_n in the racks 100 and 200 and the sub-modules 120 and 130 where the event has occurred through the voltage of the shunt resistor 20. In addition, the controller 30 may spray a fire extinguishing agent through the fire extinguishing device 40 to the corresponding position, and may further bypass the charge/discharge current for the corresponding battery cells or modules 120_1 to 130_n, thereby stopping charging and discharging operations.

Hereinafter, the operation of a controller when an event occurs in an energy storage system according to another embodiment of the present invention will be described.

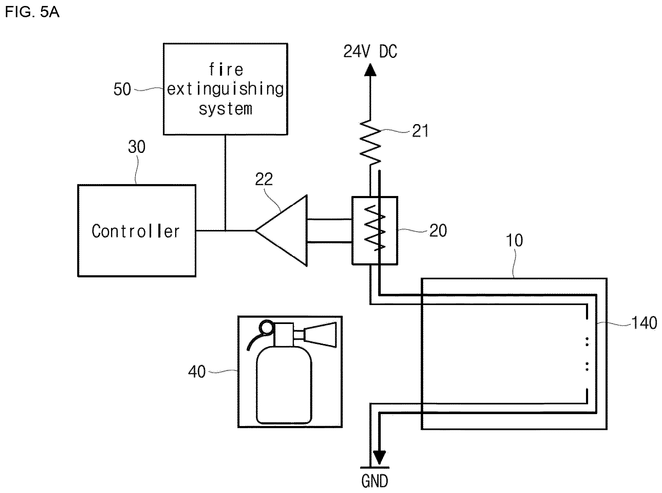

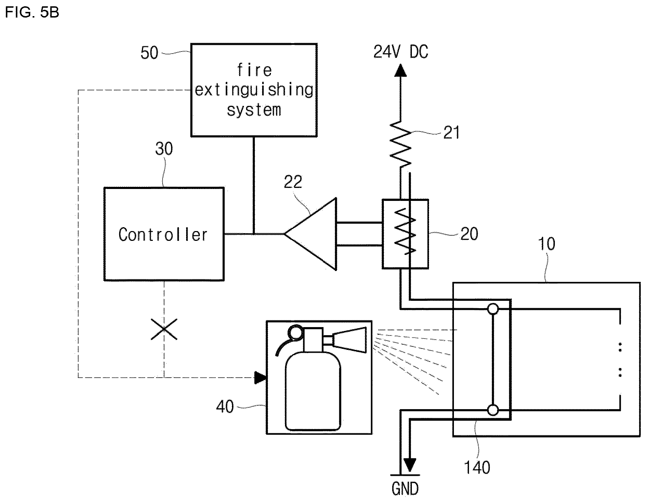

FIGS. 5A and 5B are conceptual diagrams illustrating operations when an event occurs in an energy storage system according to another embodiment of the present invention.

Referring to FIG. 5A, in the energy storage system according to another embodiment of the present invention, a controller 30 and a separate fire extinguishing system 50 may be provided, and the fire extinguishing system 50 may branch and receive an output signal of the amplifier circuit 22 connected to the shunt resistor 20. Therefore, the fire extinguishing system 50 is connected in parallel with the controller 30, and thus can operate independently of the controller 30.

Meanwhile, when a normal operation is not enabled in the controller 30 due to an internal error or malfunction, the fire extinguishing system 50 independently applies a control signal to the fire extinguishing device 40, and thus the fire extinguishing device 40 sprays the fire extinguishing agent to a battery cell in which an event occurred.

Therefore, through such a double operation, when an event occurs in a battery cell, at least spraying of a fire extinguishing agent may be performed, thereby preventing a chain explosion or fire from occurring between battery cells constituting an energy storage system.

As described above, in the energy storage system according to the present invention, a sensing line is disposed on one surface of each module installed in a rack, and thus, when an event occurs in a battery cell in a module, the positions of the corresponding module and battery cell can be accurately sensed.

While the foregoing embodiment has been described to practice the present invention, it will be understood by those of ordinary skill in the art that various changes in form and details may be made therein without departing from the scope of the present invention as defined by the following claims.

## Claims

1. An energy storage system (10) comprising:
a rack (100, 200) having a space inside;
a plurality of modules (120_1...130_n) accommodated in the rack (100, 200) and including a plurality of battery cells arranged in one direction therein; and
a sensing line (140) formed along one side of the plurality of modules (120_1...130_n);
**characterised in that** the energy storage system (10) further comprises:
a shunt resistor connected in series with the sensing line,
wherein the sensing line (140) is connected between power supply and ground (GND) lines through the shunt resistor (20);
and a controller (30) connected to the shunt resistor (20).

2. The energy storage system (10) of claim 1, wherein the sensing line (140) is disposed in the same direction as one direction in which the plurality of battery cells are arranged in the plurality of modules (120_1...130_n).

3. The energy storage system (10) of claim 1 or claim 2, wherein the sensing line (140) is arranged in alternating directions for the plurality of modules (120_1...130_n) positioned vertically in the rack (100, 200).

4. The energy storage system (10) of any one of claims 1 to 3, wherein the sensing line (140) is configured as a constant-temperature sensing linear sensor.

5. The energy storage system (10) of any one of claims 1 to 4, wherein the sensing line (140) has a wiring structure formed by twisting a steel wire coated with a temperature sensitive material.

6. The energy storage system (10) of any of claims 1 to 5, wherein the controller (30) is configured to receive a voltage of both ends of the shunt resistor (20) as an input value.

7. The energy storage system (10) of claim 6, further comprising a fire extinguishing system (40) that is connected in parallel with the controller (30) and is configured to receive a voltage of both ends of the shunt resistor (20) as an input value.

8. The energy storage system (10) of claim 6 or 7, wherein the controller (30) or the fire extinguishing system (40) is configured to apply a control signal to spray a fire extinguishing agent to a fire extinguishing device (40) when the voltage across the shunt resistor (20) is sensed.

## Patentansprüche

1. Energiespeichersystem (10), umfassend:
ein Gestell (100, 200) mit einem Raum im Inneren;
eine Vielzahl von Modulen (120_1... 130_n), die in dem Gestell (100, 200) untergebracht sind und eine Vielzahl von darin in einer Richtung angeordneten Batteriezellen einschließen; und
eine entlang einer Seite der Vielzahl von Modulen (120_1... 130_n) gebildete Messleitung (140);
**dadurch gekennzeichnet, dass** das Energiespeichersystem (10) weiter Folgendes umfasst:
einen Shuntwiderstand, der mit der Messleitung in Reihe verbunden ist,
wobei die Messleitung (140) durch den Shuntwiderstand (20) zwischen der Stromversorgungsleitung und der Masseleitung (GND) verbunden ist;
und eine Steuereinheit (30), die mit dem Shuntwiderstand (20) verbunden ist.

2. Energiespeichersystem (10) nach Anspruch 1, wobei die Messleitung (140) in der gleichen Richtung angebracht ist wie eine Richtung, in der die Vielzahl von Batteriezellen in der Vielzahl von Modulen (120_1... 130_n) angeordnet sind.

3. Energiespeichersystem (10) nach Anspruch 1 oder Anspruch 2, wobei die Messleitung (140) für die Vielzahl von Modulen (120_1... 130_n), die vertikal in dem Gestell positioniert (100, 200) sind, in abwechselnden Richtungen angeordnet ist.

4. Energiespeichersystem (10) nach einem der Ansprüche 1 bis 3, wobei die Messleitung (140) als ein linearer Sensor konfiguriert ist, der konstant Temperatur misst.

5. Energiespeichersystem (10) nach einem der Ansprüche 1 bis 4, wobei die Messleitung (140) eine Verdrahtungsstruktur aufweist, die durch Verdrillen eines mit einem temperaturempfindlichen Material beschichteten Stahldrahts gebildet wird.

6. Energiespeichersystem (10) nach einem der Ansprüche 1 bis 5, wobei die Steuereinheit (30) konfiguriert ist, um eine Spannung an beiden Enden des Shuntwiderstands (20) als einen Eingangswert aufzunehmen.

7. Energiespeichersystem (10) nach Anspruch 6, weiter umfassend ein Feuerlöschsystem (40), das mit der Steuereinheit (30) parallel verbunden ist und konfiguriert ist, um eine Spannung an beiden Enden des Shuntwiderstands (20) als einen Eingangswert aufzunehmen.

8. Energiespeichersystem (10) nach Anspruch 6 oder 7, wobei die Steuereinheit (30) oder das Feuerlöschsystem (40) konfiguriert ist, um ein Steuersignal an eine Feuerlöschvorrichtung (40) anzulegen, um ein Feuerlöschmittel zu sprühen, wenn die Spannung über den Shuntwiderstand (20) gemessen wird.

## Revendications

1. Système de stockage d'énergie (10) comprenant :
un rack (100, 200) doté d'un espace à l'intérieur;
une pluralité de modules (120_1... 130_n) logés dans le rack (100, 200) et incluant une pluralité de cellules de batterie agencées dans une direction à l'intérieur ; et
une ligne de détection (140) formée le long d'un côté de la pluralité de modules (120_1... 130_n) ;
**caractérisé en ce que** le système de stockage d'énergie (10) comprend en outre :
une résistance shunt connectée en série avec la ligne de détection,
dans lequel la ligne de détection (140) est connectée entre les lignes d'alimentation et de masse (GND) via la résistance shunt (20) ;
et un dispositif de commande (30) connecté à la résistance shunt (20).

2. Système de stockage d'énergie (10) selon la revendication 1, dans lequel la ligne de détection (140) est disposée dans la même direction que l'une des directions d'agencement des cellules de batterie dans la pluralité de modules. (120_1... 130_n).

3. Système de stockage d'énergie (10) selon la revendication 1 ou 2, dans lequel la ligne de détection (140) est agencée dans des directions alternées pour la pluralité de modules (120_1... 130_n) positionnés verticalement dans le rack (100, 200).

4. Système de stockage d'énergie (10) selon l'une quelconque des revendications 1 à 3, dans lequel la ligne de détection (140) est configurée comme un capteur linéaire de détection de température constante.

5. Système de stockage d'énergie (10) selon l'une quelconque des revendications 1 à 4, dans lequel la ligne de détection (140) présente une structure de câblage formée en torsadant un fil d'acier recouvert d'un matériau thermosensible.

6. Système de stockage d'énergie (10) selon l'une quelconque des revendications 1 à 5, dans lequel le dispositif de commande (30) est configuré pour recevoir une tension des deux extrémités de la résistance shunt (20) comme valeur d'entrée.

7. Système de stockage d'énergie (10) selon la revendication 6, comprenant en outre un système d'extinction d'incendie (40) connecté en parallèle avec le dispositif de commande (30) et configuré pour recevoir une tension des deux extrémités de la résistance shunt (20) comme valeur d'entrée.

8. Système de stockage d'énergie (10) selon la revendication 6 ou 7, dans lequel le dispositif de commande (30) ou le système d'extinction d'incendie (40) est configuré pour appliquer un signal de commande afin de pulvériser un agent extincteur sur un dispositif d'extinction d'incendie (40) lorsque la tension aux bornes de la résistance shunt (20) est détectée.
